# EUROPÄISCHE PATENTSCHRIFT

(11) **EP 1 999 783 B1**
(45) Veröffentlichungstag und Bekanntmachung des Hinweises auf die Patenterteilung: **16.02.2011**
(21) Anmeldenummer: 07726749.0
(22) Anmeldetag: 09.03.2007
(51) Int. Cl.: H01L 21/225

(54) **VERFAHREN ZUR HERSTELLUNG EINER HALBLEITERSTRUKTUR**
METHOD FOR FABRICATING A SEMICONDUCTOR STRUCTURE
PROCÉDÉ DE FABRICATION D'UNE STRUCTURE SEMI-CONDUCTRICE

(30) Priorität: 21.03.2006 DE 102006012857
(43) Veröffentlichungstag der Anmeldung: 10.12.2008
(73) Patentinhaber: Robert Bosch GmbH, 70442 Stuttgart (DE)
(72) Erfinder: BENZEL, Hubert, 72124 Pliezhausen (DE); ILLING, Matthias, 72127 Kusterdingen (DE); LAERMER, Franz, 71263 Weil der Stadt (DE); KRONMUELLER, Silvia, 71409 Schwaikheim (DE); FARBER, Paul, 70193 Stuttgart (DE); ARMBRUSTER, Simon, 72810 Gomaringen (DE); LAMMEL, Gerhard, 72070 Tuebingen (DE); REICHENBACH, Ralf, 73732 Esslingen (DE); SCHELLING, Christoph, 72762 Reutlingen (DE); FEYH, Ando, 71732 Tamm (DE)
(86) Internationale Anmeldenummer: PCT/EP2007/052227
(87) Internationale Veröffentlichungsnummer: WO 2007/107461

(56) Entgegenhaltungen:
- EP-A- 1 265 293
- WO-A-97/40527
- FR-A1- 2 655 193
- JP-A- 51 132 974
- KOVALEVSKII A A ET AL: "Void Transformation and Dopant Distribution in Porous Silicon" RUSSIAN MICROELECTRONICS, Bd. 36, Nr. 1, Februar 2007 (2007-02), Seiten 49-52, XP002432572
- DEHU P ET AL: "P wells made of porous silicon for power devices: Determination of the formation steps" THIN SOLID FILMS, ELSEVIER-SEQUOIA S.A. LAUSANNE, CH, Bd. 255, Nr. 1/2, 15. Januar 1995 (1995-01-15), Seiten 321-324, XP004010569 ISSN: 0040-6090
- AMATO G ET AL: "Deep "cold" junctions by porous silicon impregnation" THIN SOLID FILMS, ELSEVIER-SEQUOIA S.A. LAUSANNE, CH, Bd. 297, Nr. 1-2, 1. April 1997 (1997-04-01), Seiten 321-324, XP004126021 ISSN: 0040-6090
- ASTROVA E V ET AL: "DEEP DIFFUSION DOPING OF MACROPOROUS SILICON" PHYSICA STATUS SOLIDI (A). APPLIED RESEARCH, BERLIN, DE, Bd. 182, Nr. 1, 16. November 2000 (2000-11-16), Seiten 145-150, XP009082971 ISSN: 0031-8965
- POPONIAK M R ET AL: "ENHANCED DIFFUSION IN POROUS SILICON" IBM TECHNICAL DISCLOSURE BULLETIN, IBM CORP. NEW YORK, US, Bd. 17, Nr. 6, November 1974 (1974-11), Seiten 1598-1599, XP002046555 ISSN: 0018-8689

## Beschreibung

### Stand der Technik

Die vorliegende Erfindung betrifft ein Verfahren zur Herstellung einer Halbleiterstruktur .

Im weiteren Sinne betrifft die vorliegende Erfindung eine Veränderung der Materialeigenschaften von einem Halbleitersubstrat, aus Silizium oder Siliziumcarbid ausgehend von einer Oberfläche des Halbleitersubstrats. Derartige Veränderungen können beispielsweise in der Einstellung einer bestimmten Leitfähigkeit oder Leitfähigkeitstyps bestehen (p- oder n-Dotierung).

Obwohl prinzipiell auch auf zahlreiche andere mikromechanische bzw. mikroelektronische Halbleiterstrukturen anwendbar, werden die vorliegende Erfindung sowie die ihr zugrundeliegende Problematik anhand von mikromechanischen Drucksensoren erläutert.

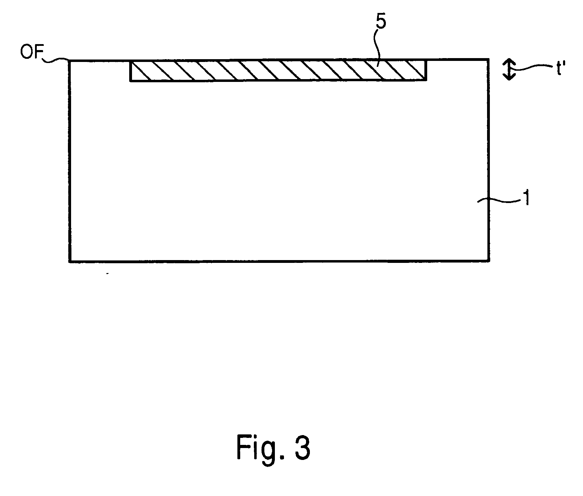

Fig. 3 zeigt eine schematische Querschnittsansicht einer bekannten Halbleiterstruktur. In Fig. 3 bezeichnet Bezugszeichen 1 ein Halbleitersubstrat aus Silizium, beispielsweise vom p-Typ, und Bezugszeichen 5 einen Dotierungsbereich an der Oberfläche OF des Halbleitersubstrats 1, beispielsweise vom n-Typ, der eine Tiefe t' von 10 µm aufweist.

Üblicherweise werden derartige Dotierungsbereiche 5 durch Diffusion von Fremdatomen in das Halbleitersubstrat 1 ausgehend von der Oberfläche OF bewirkt. Im Fall eines Silizium-Halbleitersubstrats 1 wird hierzu entweder eine Quelle von Dotierstoffen auf der Waferoberfläche abgeschieden (z. B. Phosphorglas für p-Dotierung oder Borglas für p-Dotierung) und danach bei hoher Temperatur thermisch eingetrieben, d. h. die Dotierstoffe zur Diffusion ins Silizium-Halbleitersubstrat 1 ausgehend von der Oberfläche OF angeregt. Alternativ können die Dotierstoffe in die Waferoberfläche in eine Schicht von typischerweise 1 bis 2 µm Ursprungsdicke implantiert werden, die nachträglich thermisch tiefer ins Silizium-Halbleitersubstrat 1 eindiffundiert wird.

Solche Diffusionsvorgänge sind generell auf eine relativ geringe Schichtdicke ausgehend von der Oberfläche OF des Halbleitersubstrats 1 beschränkt, da Fremdstoffe, wie z. B. Dotierstoffatome, in Silizium auch bei sehr hohen Temperaturen nur langsam diffundieren und daher in der Praxis nur Tiefen von typischerweise 20 bis 25 µm in Silizium erreichen können, zumindest innerhalb wirtschaftlich vertretbarer Diffusionszeiten. Auch gibt es Fremdatome wie z. B. Antimon (Sb) oder Germanium (Ge) usw., die aufgrund ihrer großen Atomdurchmesser nur außerordentlich langsam eindiffundieren, so dass das angegebene Limit von typischerweise 20 bis 25 µm in Silizium mit diesen Fremdatomen nicht einmal erreicht werden kann, sondern die Diffusionstiefen innerhalb vertretbarer Zeiten demgegenüber deutlich zurückbleiben.

Im Falle von Siliziumcarbid kommt zusätzlich erschwerend hinzu, dass eine Diffusion selbst bei extrem hohen Temperaturen von 1.400°C extrem langsam erfolgt. Das Gitter von Siliziumcarbid ist eine beträchtliche Diffusionsbarriere, die ein Eindringen von Fremdatomen stark blockiert und Diffusionsvorgänge auf wenige Mikrometer Eindringtiefe begrenzt.

Insbesondere bei mikromechanischen Anwendungen werden jedoch häufig dickere Schichten von z.B. Silizium oder Siliziumcarbid mit veränderten Schichteigenschaften, z. B. einer veränderten elektrischen Leitfähigkeit oder eines veränderten elektrischen Leitfähigkeitstyps, benötigt, so dass die angegebenen Grenzen von thermischen Diffusionsprozessen im Bulk-Material stören. Als Beispiele können hierfür dicke einkristalline Siliziumschichten vom n-Typ mit beispielsweise 100 bis 200 µm Dicke auf einem p-Halbleitersubstrat genannt werden wie man sie für Hochdrucksensoren in Silizium in Verbindung mit einem elektrochemischen Ätzstopp von p- nach n-Silizium vorteilhaft einsetzen würde. Das gilt auch für die Herstellung von dicken Silizium-Biegebalken durch einen elektrochemischen Ätzstopp von der Rückseite her und in Plasma-Trench-Technik von der Vorderseite her sowie die Herstellung von dünnen Silizium-Filmen von 100 bis 200 µm Dicke und gewünschter Dotierung durch elektrochemisches Ätzen oder Anodisieren bis zu einem pn-Übergang. Entsprechendes gilt auch für Siliziumcarbid im Falle medienresistenter hochtemperaturtauglicher Sensoren, wie auch für die Herstellung von Siliziumcarbid-Filmen mittels bekannter Smart-Cut-Verfahren über dotierungsselcktive elektrochemische Anodisierungs- oder Ätzverfahren.

Aus der DE 100 32 579 A1 und der DE 10 2004 036 032 A1 ist es bekannt, wie poröse Bereiche in Silizium-Halbleitersubstraten hergestellt werden können. Darüber hinaus beschreiben auch die Schriften "P wells made of porous silicon for power devices: determination of the formation Stepps" (Dehu et al, Thin Solid Films 255 (1995), 321) sowie "Deep cold junctions by porous silicon impregnation" (Amato et al, Thin Solid Films 297 (1997), 321) entsprechende Herstellungsverfahren für poröse Bereiche in Silizium-Halbleitersubstraten.

Die der vorliegenden Erfindung zugrunde liegende Problematik besteht also in der Bereitstellung eines Verfahrens zur Herstellung einer Halbleiterstruktur , welches eine prozesstechnisch einfache Herstellung tiefer Dotierungsgebiete in einem Halbleitersubstrat ermöglicht.

### Vorteile der Erfindung

Das erfindungsgemäße Verfahren zur Herstellung einer Halbleiterstruktur nach Anspruch 1 weist den Vorteil auf, dass es die Herstellung dicker Schichten von kristallinem Halbleitermaterial aus Silizium oder Siliziumcarbid mit veränderten Eigenschaften durch Einbringen von Fremdatomen oder Fremdstoffen ermöglicht. Dabei können zum Einen modifizierte Schichten in so großer Dicke hergestellt werden, die in diesen großen Schichtdicken anders nicht wirtschaftlich herstellbar sind. Zum Anderen können Fremdatome eingebracht werden, die selbst nur sehr langsam diffundieren und daher nach dem Stand der Technik nicht auf praktikable Art und Weise in Schichten eingebracht werden können, z. B. Antimon oder Germanium oder andere Atome mit großem Atomradius.

Darüber hinaus können mit den vorbeschriebenen Verfahren gänzlich neue Materialeigenschaften erzielt werden durch Einbringen großer Mengen an Fremdatomen, die anders gar nicht in solch hohen Dosen einbringbar wären.

In den Unteransprüchen finden sich vorteilhafte Weiterbildungen und Verbesserungen des jeweiligen Gegenstandes der Erfindung.

Die der vorliegenden Erfindung zugrunde liegende Idee besteht darin, einen porösen Bereich angrenzend an eine Oberfläche eines Halbleitersubstrats zu schaffen, in den ein Dotierstoff eingebracht wird, wonach der poröse Bereich thermisch rekristallisiert wird.

Zum Vorsehen des porösen Bereichs wird zweckmäßigerweise das Verfahren elektrochemischer Anodisierung verwendet. Poröses Silizium oder poröses Siliziumcarbid kann dabei nanoporös oder mesoporös durch Wahl entsprechender Anodisierungsbedingungen, im wesentlichen Stromdichte und Flusssäurekonzentration, erzeugt werden.

Es ist mittels elektrochemischer Anodisierung ohne weiteres möglich, dicke poröse Schichten von beispielsweise 100 bis 300 µm vertikaler Ausdehnung herzustellen. Dieses Skelett aus nanoskaligem bzw. mesoskaligem Silizium oder Siliziumcarbid kann anschließend in voller Dicke mit Fremdatomen versehen werden.

Hierzu können die Dotierstoffe entweder in Form eines Trägergases zugeführt werden (z. B. Diboran, Arsin, Phosphin usw.), das in die Struktur eindringt. Alternativ kann ein Glas, z. B. Borglas oder Phosphorglas, auf die Oberfläche abgeschieden werden oder ein in Flüssigkeit gelöster Precursor in die poröse Struktur eingetränkt werden. Als Precursor bieten sich organische und anorganische Verbindungen von Bor, Phosphor (z. B. Trimethylphosphit, Phosphorpentaxyd), Arsen (Vinylarsin), Antimon, Germanium (Tetraethylgerman), Aluminium, Eisen, Blei usw. oder deren lösliche Salze (z. B. Chloride, Iodide, Bromide ...) an, die in Flüssigkeiten mit niedriger Oberflächenspannung, wie z. B. Alkoholen oder Wasser oder Alkohol-Wassergemischen oder anderen organischen Lösungsmitteln gelöst werden können. Bei einer bevorzugten Ausführungsform werden die Dotierstoffe in Form eines Trägergases zugeführt, wobei das Gas den porösen Bereich bei hoher Temperatur von beispielsweise 900 °C homogen durchsetzt und die Fremdatome gleichzeitig aus der Gasphase in die Nanostruktur eindiffundieren. Bei diesem Ausführungsbeispiel fallen die Temperaturbehandlung zur Abscheidung und die Temperaturbehandlung zum Eintreiben des Dotierstoffes zeitlich zusammen.

Besonders vorteilhaft ist es, Dotieratome in superkritischem CO₂ zu lösen, da dieser Stoff keine Oberflächenspannung aufweist und dadurch besonders leicht Nanostrukturen bzw. Mesostrukturen zu durchdringen und zu funktionalisieren, d. h. mit Fremdatomen zu beschichten, vermag, Eventuell ist es zweckmäßig, dem superkritischen CO₂ noch sogenannte Co-solvents (Zusatzlösemittel) zuzusetzen, um in CO₂ schwerlösliche Fremdstoffe durch Solvatisierung in Lösung zu bringen. Der Vorteil des superkritischen Zustands ist wie gesagt die Tatsache, dass jeder Punkt in der Tiefe des porösen Materials mühelos erreicht werden kann und die Fremdstoffe überallhin in annähernd gleicher Konzentration transportiert und abgeschieden werden können. Bei bevorzugten Ausführungsform kann ein Tränken des porösen Bereichs mit einer Lösung von Fremdatomen in einer Flüssigkeit, insbesondere in superkritischem CO₂, bei Raumtemperatur stattfinden, wonach unmittelbar anschließend ein Temperaturschritt bei 900 °C zum Eintreiben und ein weiterer bei 950°C zur Rekristallisierung und zum Eintreiben stattfinden.

Vorzugsweise wird der Schritt des thermischen Eintreibens der Fremdatome separat bei einer Temperatur durchgeführt, bei der noch keine strukturelle Umlagerung stattfinden kann. Dabei diffundieren die Fremdatome bei einer Temperatur von beispielsweise 900°C in Silizium im gesamten Volumen der porösen Struktur in die filigranen Nanostrukturen ein und durchdringen diese nahezu homogen. Dabei wird die Stabilität der Nanostruktur zusätzlich unterstützt durch die Tatsache, dass natürliche Oxide auf den Strukturoberflächen diese zusätzlich stabilisieren und eine thermische Umlagerung verhindern. Im Falle des Siliziums zerfallen derartige Oxide erst oberhalb von 950°C, im Falle von Siliziumcarbid erst oberhalb von 1.200°C.

Im Rekristallisierungsschritt wird der poröse Bereich bei hohen Temperaturen, z.B. von oberhalb 950°C im Fall von Silizium und von oberhalb 1.200°C im Fall von Siliziumcarbid thermisch kollabiert, wobei sich durch Umlagerung der Siliziumatome bzw. des Siliziumcarbids erneut eine einkristalline massive Schicht im Sinne von Bulkmaterial ergibt. Diese Umlagerung war anfangs noch unerwünscht, damit die Fremdatome die Nanostruktur noch überall erreichen konnten und es nicht zu Verletzungen einzelner Bereiche der Struktur kam. Bei diesen erhöhten Temperaturen werden nun die nativen, die nanostrukturstützenden Oxidschichten abgedampft, was durch Zusatz von Wasserstoffgas noch zusätzlich unterstützt werden kann. Ohne die Stabilisierung durch die Oberflächenoxide kann die thermische Umlagerung der Struktur rasch einsetzen und sich bis zu einer kompletten Verdichtung zu einem einkristallinen Material fortsetzen. Somit ist es möglich, dicke Schichten von Silizium oder Siliziumcarbid kontrolliert mit Fremdatomen zu durchsetzen, und zwar in einem insgesamt wirtschaftlichen Gesamtprozess mittels einer elektrochemischen Anodisierung in Verbindung mit relativ einem oder mehreren kurzen Hochtemperaturschritten.

### Zeichnungen

Ausführungsbeispiele der Erfindung sind in den Zeichnungen dargestellt und werden in der nachfolgenden Beschreibung näher erläutert.
- Fig. 1 a-d: zeigen schematische Querschnittsansichten der wesentlichen Herstellungsschritte eines Verfahrens zur Herstellung einer Halbleiterstruktur gemäß einer Ausführungsform der vorliegenden Erfindung;
- Fig. 2: zeigt ein Fliessdiagramm zum Erläutern des Ablaufs der wesentlichen Herstellungs- schritte des Verfahrens zur Herstellung einer Halbleiterstruktur gemäß der Ausfüh- rungsform der vorliegenden Erfindung; und
- Fig. 3: zeigt eine schematische Querschnittsansicht einer bekannten Halbleiterstruktur

### Beschreibung der Ausführungsbeispiele

In den Figuren bezeichnen gleiche Bezugszeichen gleiche oder funktionsgleiche Komponenten.

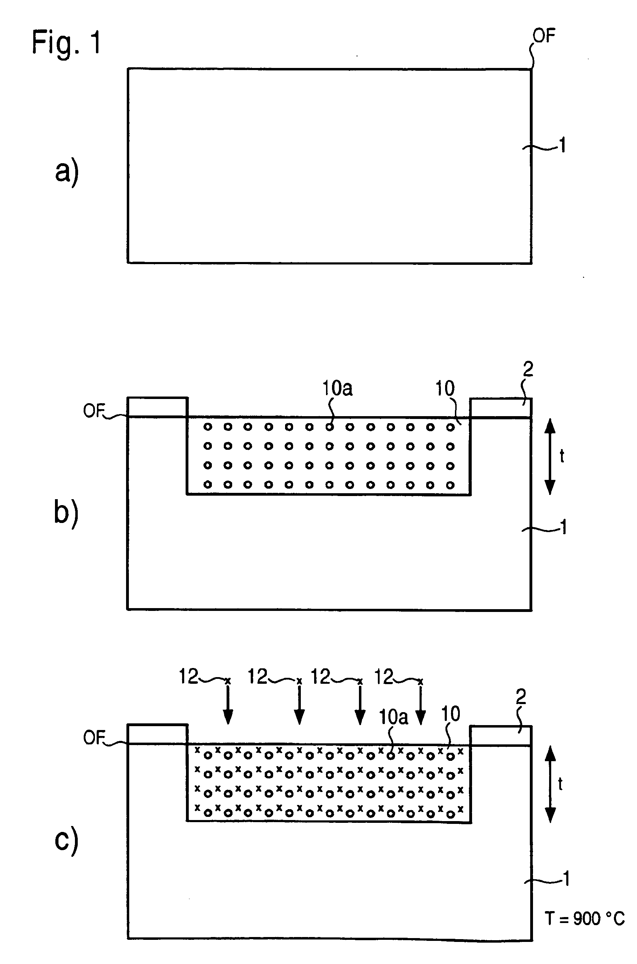

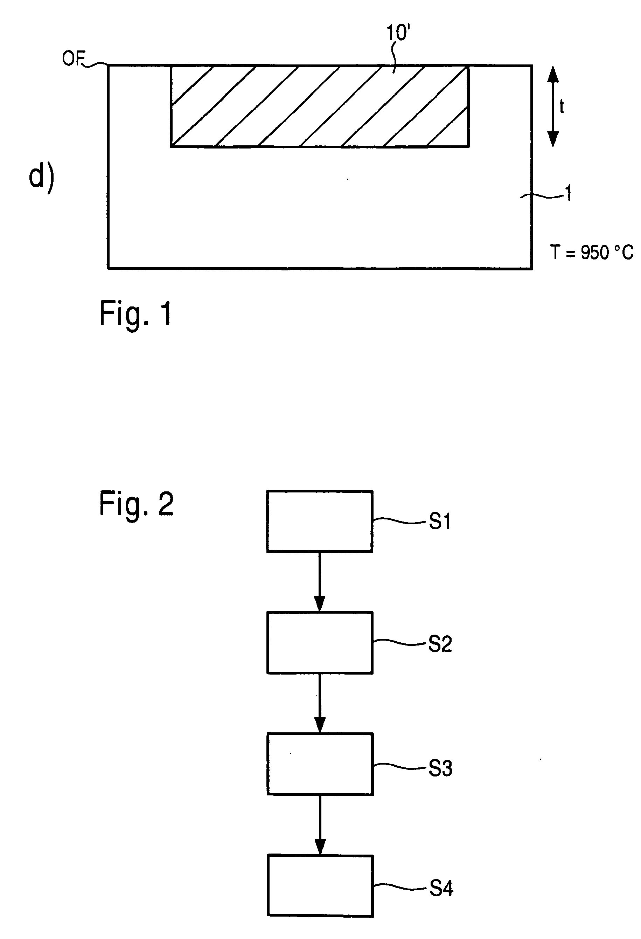

Fig. 1a-d zeigen schematische Querschnittsansichten der wesentlichen Herstellungsschritte eines Verfahrens zur Herstellung einer Halbleiterstruktur gemäß einer Ausführungsform der vorliegenden Erfindung, und Fig. 2 zeigt ein Fliessdiagramm zum Erläutern des Ablaufs der wesentlichen Herstellungsschritte des Verfahrens zur Herstellung einer Halbleiterstruktur gemäß der Ausführungsform der vorliegenden Erfindung.

In Fig. 1a bezeichnet Bezugszeichen 1 ein Silizium-Halbleitersubstrat vom p-Typ mit einer Oberfläche OF.

Gemäß Fig. 1b wird auf der Oberfläche OF eine Maske 2 aus Siliziumnitrid aufgebracht (Schritt S1) und anschließend durch eine elektrochemische Anodisierung ein nanoporöser Bereich 10 mit einer Tiefe t von 100 µm eingebracht (Schritt S2), welcher ein Geflecht von Poren 10a aufweist, die ein miteinander verbundenes Skelett bilden.

In einem anschließenden Prozessschritt S3, der in Fig. 1c gezeigt ist, wird zunächst ein Glas 12, beispielsweise Phosphorglas, in den porösen Bereich 10 bei einer Temperatur von 900 °C eingebracht, wobei bei dieser Temperatur unmittelbar gleichzeitig auch ein Eindiffundieren des Phosphors in das Skelett aus nanoskaligem Silizium erfolgt und letzteres somit homogen vom Phosphor durchdrungen wird.

Weiter mit Bezug auf Fig. 1d erfolgt dann ein Temperaturschritt S4 bei einer Temperatur von mehr als 950°C, wobei sich durch Umlagerung der Siliziumatome ein thermisches Rekristallisieren des porösen Bereich 10 in einen kristallinen Dotierungsbereich 10' des Halbleitersubstrats 1 ergibt, dessen Dotierungsart, Dotierungskonzentration und Dotierungsverteilung von derjenigen bzw. denjenigen des Halbleitersubstrat 1 abweicht.

Obwohl die vorliegende Erfindung anhand eines bevorzugten Ausführungsbeispiels beschrieben wurde, ist sie nicht darauf beschränkt.

Alternativ zum obigen Ausführungsbeispiel können die Dotierstoffe entweder in Form eines Trägergases oder in Form einer flüssigen Lösung, das in die poröse Struktur eindringt.

Obwohl beim obigen Beispiel die Halbleiterstruktur unter Verwendung der Maske aus Siliziumnitrid gebildet worden ist, ist es auch möglich, eine Randdotierung im Halbleitersubstrat vorzusehen, welche den porös zu machenden Bereich seitlich umgibt und als Ätzmaske dient. Auch kann für den anodischen Prozess eine Aufdotierung der Rückseite des Substrats vorgesehen werden.

Die beim obigen Beispiel erwähnte Anwendung für einen mikromechanischen Drucksensor ist rein beispielhaft und kann beliebig modifiziert werden.

## Patentansprüche

1. Verfahren zur Herstellung einer Halbleiterstruktur mit den Schritten:
Bereitstellen eines kristallinen Halbleitersubstrats (1) bestehend aus Silizium oder Siliziumcarbid;
Vorsehen eines porösen Bereichs (10) angrenzend an einer Oberfläche (OF) des Halbleitersubstrats (1);
Einbringen von einem Dotierstoff (12) in den porösen Bereich (10) von der Oberfläche (OF) aus; und
Durchführen eines Temperaturschritts zur Umlagerung der Siliziumatome bzw. des Siliziumcarbids des porösen Bereich (10) in einen einkristallinen massiven Dotierungsbereich (10') des Halbleitersubstrats (1), dessen Dotierungsart und/oder Dotierungskonzentration und/oder Dotierungsverteilung von derjenigen bzw. denjenigen des Halbleitersubstrat (1) abweicht,
wobei der Temperaturschritt zu Umlagerung des porösen Bereich (10) in Wasserstoffatmosphäre durchgeführt wird.

2. Verfahren nach Anspruch 1, **dadurch gekennzeichnet, dass** während oder nach dem Einbringen des Dotierstoffs (12) ein erster Temperaturschritt bei einer ersten Temperatur durchgeführt wird, bei der keine strukturelle Umwandlung des porösen Bereichs (10) stattfindet.

3. Verfahren nach Anspruch 2, **dadurch gekennzeichnet, dass** nach dem ersten Temperaturschritt ein zweiter Temperaturschritt bei einer zweiten Temperatur unmittelbar anschliessend durch Temperaturerhöhung von der ersten zur zweiten Temperatur durchgeführt wird, bei der eine strukturelle Umwandlung des porösen Bereichs (10) bis hin zum thermischen Rekristallisieren in den kristallinen Dotierungsbereich (10') stattfindet.

4. Verfahren nach einem der vorhergehenden Ansprüche, **dadurch gekennzeichnet, dass** der Dotierstoff (12) in Form eines Trägergases in den porösen Bereich (10) eingebracht wird.

5. Verfahren nach einem der vorhergehenden Ansprüche, **dadurch gekennzeichnet, dass** der Dotierstoff (12) als Bestandteil eines Glases in den porösen Bereich (10) eingebracht wird.

6. Verfahren nach einem der vorhergehenden Ansprüche, **dadurch gekennzeichnet, dass** der Dotierstoff (12) in einer Flüssigkeit gelöst in den porösen Bereich (10) eingebracht wird.

7. Verfahren nach Anspruch 6, **dadurch gekennzeichnet, dass** die Flüssigkeit superkritisches CO₂ aufweist.

8. Verfahren nach Anspruch 6, **dadurch gekennzeichnet, dass** die Flüssigkeit ein Co-Solvent aufweist.

## Claims

1. Method for fabricating a semiconductor structure comprising the following steps:
providing a crystalline semiconductor substrate (1) consisting of silicon or silicon carbide;
providing a porous region (10) adjoining a surface (OF) of the semiconductor substrate (1);
introducing a dopant (12) into the porous region (10) from the surface (OF); and
carrying out a thermal step for rearranging the silicon atoms or the silicon carbide of the porous region (10) into a massive monocrystalline doping region (10') of the semiconductor substrate (1), the doping type and/or doping concentration and/or doping distribution of which deviates from that or those of the semiconductor substrate (1),
wherein the thermal step for rearranging the porous region (10) is carried out in a hydrogen atmosphere.

2. Method according to Claim 1, **characterized in that**, during or after the introduction of the dopant (12), a first thermal step is carried out at a first temperature, at which no structural transformation of the porous region (10) takes place.

3. Method according to Claim 2, **characterized in that**, after the first thermal step, a second thermal step is carried out at a second temperature directly afterwards by increasing the temperature from the first temperature to the second temperature, at which a structural transformation of the porous region (10) through to thermal recrystallization into the crystalline doping region (10') takes place.

4. Method according to any of the preceding claims, **characterized in that** the dopant (12) is introduced into the porous region (10) in the form of a carrier gas.

5. Method according to any of the preceding claims, **characterized in that** the dopant (12) is introduced into the porous region (10) as a constituent of a glass.

6. Method according to any of the preceding claims, **characterized in that** the dopant (12) is introduced into the porous region (10) in a manner dissolved in a liquid.

7. Method according to Claim 6, **characterized in that** the liquid comprises supercritical CO₂.

8. Method according to Claim 6, **characterized in that** the liquid comprises a co-solvent.

## Revendications

1. Procédé de fabrication d'une structure semiconductrice, comprenant les étapes qui consistent à :
préparer un substrat semi-conducteur cristallin (1) constitué de silicium ou de carbure de silicium,
prévoir une partie poreuse (10) en position adjacente à une surface (OF) du substrat semi-conducteur (1),
apporter une substance de dopage (12) dans la partie poreuse (10), depuis la surface (OF) et
exécuter une étape de traitement thermique destinée à déplacer les atomes de silicium ou le carbure de silicium depuis la partie poreuse (10) jusque dans une massif partie de dopage monocristalline (10') du substrat semi-conducteur (1), le type de dopage, la concentration de dopage et/ou la répartition du dopage étant différents de ceux du substrat semi-conducteur (1),
dans lequel l'étape de traitement thermique destinée à convertir la partie poreuse (10) est exécutée dans une atmosphère d'hydrogène.

2. Procédé selon la revendication 1, **caractérisé en ce que** pendant ou après l'apport de la substance de dopage (12), une première étape de traitement thermique au cours de laquelle a lieu la conversion structurelle de la partie poreuse (10) est exécutée à une première température.

3. Procédé selon la revendication 2, **caractérisé en ce qu'**après la première étape de traitement thermique, une deuxième étape de traitement thermique à une deuxième température, au cours de laquelle une conversion structurelle de la partie poreuse (10) jusqu'à recristallisation thermique a lieu dans la partie cristalline de dopage (10'), est exécutée immédiatement ensuite par augmentation de la température depuis la première jusqu'à la deuxième température.

4. Procédé selon l'une des revendications précédentes, **caractérisé en ce que** la substance de dopage (12) est apportée dans la partie poreuse (10) sous la forme d'un vecteur gazeux.

5. Procédé selon l'une des revendications précédentes, **caractérisé en ce que** la substance de dopage (12) est apportée dans la partie poreuse (10) sous la forme d'un composant d'un verre.

6. Procédé selon l'une des revendications précédentes, **caractérisé en ce que** la substance de dopage (12) est apportée dans la partie poreuse (10) après avoir été dissoute dans un liquide.

7. Procédé selon la revendication 6, **caractérisé en ce que** le liquide présente du CO₂ hypercritique.

8. Procédé selon la revendication 6, **caractérisé en ce que** le liquide présente un co-solvant.
